# EUROPEAN PATENT APPLICATION

(11) **EP 4 597 576 A1**
(43) Date of publication of application: **06.08.2025**
(21) Application number: 24186404.0
(22) Date of filing: 04.07.2024
(51) Int. Cl.: H01L 29/10, H01L 29/423, H01L 29/778

(54) **DEVICE WITH INNER SPACER SIDEWALL STRUCTURES**

(30) Priority: 30.01.2024 US 202418427028
(71) Applicant: GlobalFoundries U.S. Inc., Malta, NY 12020 (US)
(72) Inventor: HEBERT, Francois, Santa Clara, CA 95054 (US); SUSAI, Lawrence Selvaraj, Essex Junction, VT 05452 (US); BENTLEY, Steven John, Malta, NY 12020 (US)
(74) Representative: Lambacher, Michael

(57) **Abstract**

The present disclosure relates to semiconductor structures and, more particularly, to a device with a self-aligned inner spacer sidewall structures. The structure includes: a gate structure on a semiconductor substrate; a gate metal connecting to the gate structure and offset from edges of the gate structure; and inner sidewall spacers on an upper surface of the gate structure and surrounding the gate metal.

## Description

### BACKGROUND

This invention was made with government support under Contract # HQ0727790700 awarded by the Defense Microelectronics Activity (DMEA). The government has certain rights in the invention.

The present disclosure relates to semiconductor structures and, more particularly, to a device with self-aligned inner spacer sidewall structures.

A high-electron-mobility transistor (HEMT) is a field-effect transistor incorporating a junction between two materials with different band gaps (i.e. a heterojunction) as the channel, instead of a doped region (as is generally the case for a MOSFET). Commonly used material families are GaN or GaAs, although other materials can be used, dependent on the application of the device.

Due to the higher critical field and switching figures of merit of the GaN materials system, GaN HEMT devices typically have a higher electric-field strength than silicon MOSFETS, providing substantial performance improvements in, for example, on-resistance and breakdown voltage, while offering fast switching speed, amongst other important parameters. Since these properties result in fundamentally higher system efficiency, HEMTs may be used in diverse power management applications, such as AC-DC and DC-DC conversion in the consumer or automotive space. In RF applications, they may be used in high frequency power amplifiers, low noise amplifiers or switches in such applications as cell phones, satellite or receivers or radar equipment.

### SUMMARY

In an aspect of the disclosure, a structure comprises: a gate structure on a semiconductor substrate; a gate metal connecting to the gate structure and offset from edges of the gate structure; and inner sidewall spacers on an upper surface of the gate structure and surrounding the gate metal.
Additional features of the structure are set forth in dependent claims 2 to 9.

In an aspect of the disclosure, a structure comprises: wide-bandgap semiconductor layers on a semiconductor substrate; a device including a gate structure over the wide-bandgap semiconductor layers; a dielectric material over the semiconductor substrate, the dielectric material comprising a trench over the device; inner sidewall spacers over the gate structure of the device and on sidewalls of the trench; and inner sidewall spacers over the device and on sidewalls of the trench; and a gate metal extending within the trench and connecting to the device, the gate metal being surrounded by the inner sidewall spacers.
Additional features of the structure are set forth in dependent claims 11 to 14.

In an aspect of the disclosure, a method comprises: forming a gate structure on a semiconductor substrate; forming inner sidewall spacers on an upper surface of the gate structure and; forming a gate metal connecting to the gate structure surrounded by sidewall spacers and offset from edges of the gate structure.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIGS. 2A-2E show fabrication processes for manufacturing the structure of FIG. 1 in accordance with aspects of the present disclosure.

### DETAILED DESCRIPTION

The present disclosure relates to semiconductor structures and, more particularly, to a device with a self-aligned inner spacer gate structure. More specifically, the device may be an enhancement mode (e.g., off) high-electron-mobility transistor (HEMT) with a self-aligned inner spacer gate structure. Advantageously, the self-alignment of gate metal to the edges of a gate structure can be achieved without any isotropic etch-back processes, which reduces fabrication time and costs. In addition, the device exhibits improved breakdown/capacitance by optimizing usage of the inner spacers.

In more specific embodiments, the HEMT may be a high-voltage p-GaN HEMT with a controllable formation of gate metal on top of a p-GaN gate structure. In embodiments, for example, the gate metal may be self-aligned to the underlying p-GaN gate structure by use of inner dielectric spacers. By using the self-aligned approach with the inside dielectric spacers, the gate metal can be precisely aligned to the p-GaN gate structure without causing stress or shorts.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

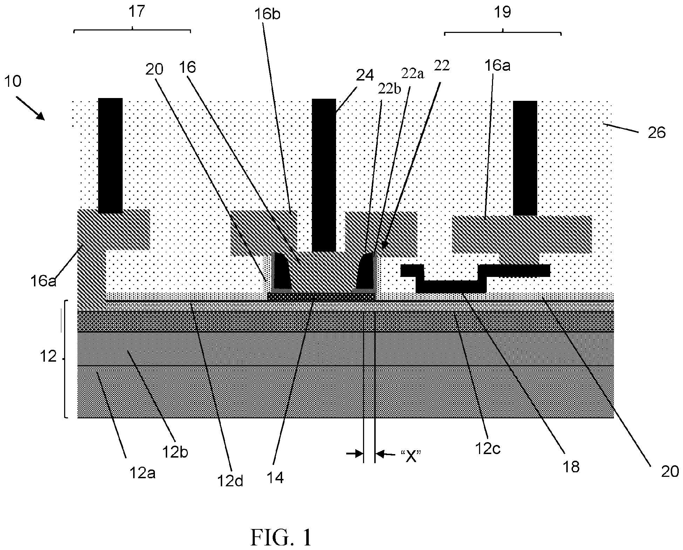

FIG. 1 shows a structure and respective fabrication processes in accordance with aspects of the present disclosure. More specifically, the structure 10 of FIG. 1 may be a HEMT comprising a gate metal 16 provided between inner dielectric spacers 22 arranged above a p-GaN gate structure 14. The gate metal 16 may be symmetrically offset by a distance "X" from edges of the p-GaN gate structure 14 by the inner dielectric spacers 22. In embodiments, the offset distance "X" is a thickness of the inner dielectric spacers 22. The inner dielectric spacers 22 may be a single dielectric material (e.g., oxide or nitride) or multiple layers of dielectric material (e.g., oxide layer 22a and nitride layer 22b).

More specifically, the structure 10 includes a semiconductor substrate 12. The semiconductor substrate 12 may comprise a semiconductor handle substrate 12a comprising Si; although other suitable materials are contemplated herein including, but not limited to, SiGe, SiGeC, SiC, GaN, AlN, GaAs, InAs, InP, and other III/V or II/VI compound semiconductors, or may be an engineered substrate with multiple layers, such as silicon-on-insulator (SOI). In preferred embodiments, the semiconductor material substrate may comprise a suitable crystal orientation, e.g., <111> in the case of silicon.

A wide-bandgap semiconductor layer 12b may be formed on the semiconductor handle substrate 12a. The wide-bandgap semiconductor layer 12b may be, for example, an AlGaN stack of materials as is known in the art. For example, and as a non-limiting illustrative example, the wide-bandgap semiconductor layer 12b may comprise, in a layered stack of semiconductor materials, a seed layer, e.g., AlN, on the underlying semiconductor substrate 12a, with a buffer layer (e.g., AlGaN/GaN superlattices) and a channel layer 12c, e.g., GaN. In embodiments, the channel layer 12c may be undoped GaN formed over the wide-bandgap semiconductor layer 12b, with an AlGaN layer 12d formed over the undoped GaN. In other embodiments, the layer 12d may be AlN, InAlN, InGaN, GaN or multiple materials. The stack of semiconductor materials may be formed by conventional epitaxial growth processes or other known deposition methods, e.g., metal-organic chemical vapor deposition (MOCVD) or molecular beam epitaxy (MBE).

Still referring to FIG. 1, the device 10 may be provided over the channel layer 12c. In embodiments, the device (e.g., gate structure) 14 may be provided between a source region 17 and a drain region 19 (e.g., active regions) of the channel layer 12c. The device 10 may be a HEMT comprising semiconductor material formed, e.g., deposited and patterned, on the stack of semiconductor materials, e.g., the channel layer 12c of the semiconductor substrate 12. In embodiments, the semiconductor material of the device 10 includes, e.g., p-doped GaN 14 (an e-mode device) in Figure 1. The semiconductor material may be epitaxially grown with an in-situ doping, e.g., p-type doping such as magnesium (Mg), as is known in the art.

A gate metal stack 16, e.g., TiN, TiAl and/or TaN, may be provided on top of and contacting the semiconductor material of gate 14, the device 10. Also, a metal stack 16a (ohmic metal) may be connecting to a metal field plate 18, e.g., TiN, TiAl and/or TaN in the drain region 19 and the wide-bandgap semiconductor layer 12b-12d in the source region 17, to form a source ohmic contact. The metal stacks 16, 16a and the field plate 18 may be deposited by a conventional deposition method (e.g., CVD, PVD, ALD and other techniques), followed by conventional lithography and etching (e.g., patterning) processes as is known in the art.

The metal 16, 16a may be composed of different metal layers since each metal layer may have a different purpose. For example, metal 16 may be used to form a Schottky Barrier Diode contact to the P-GaN Gate, and therefore, Titanium (Ti) is a preferred metal to directly contact the P-GaN Gate layer. Additional metal layers can be included on top of the Ti layer, including Aluminum. The metal 16a may be used to form low resistance ohmic contacts to the two dimensional electron gas layer (2DEG) formed at the interface of the AlGaN layer 12d and undoped-GaN channel layers 12c, and the source and drain electrodes of the HEMT devices. The Ohmic metal may include a combination of Aluminum, Silicon and other metals as is known in the art.

The field plate 18 may be formed on a passivation layer 20, above and isolated from the channel layer 12c and donor layer 12d. The passivation layer 20 may be, for example, silicon nitride, silicon oxide, aluminum oxide, or multiple materials, and may be deposited using ALD, CVD, or any other known method. Moreover, the passivation layer 20 may be formed over the semiconductor substrate 12 and contacts edges of the gate layer 14 of the active device 10, e.g., p-GaN gate structure.

Still referring to FIG. 1, the gate metal stack 16 provided on the active device 10 may be self-aligned and surrounded by the inner dielectric spacers 22. The inner dielectric spacers 22 may be a single layer of a dielectric insulator material, e.g., oxide or nitride, or multiple layers of insulator material. For example, the dielectric spacers may be a combination of oxide material 22a and nitride material 22b.

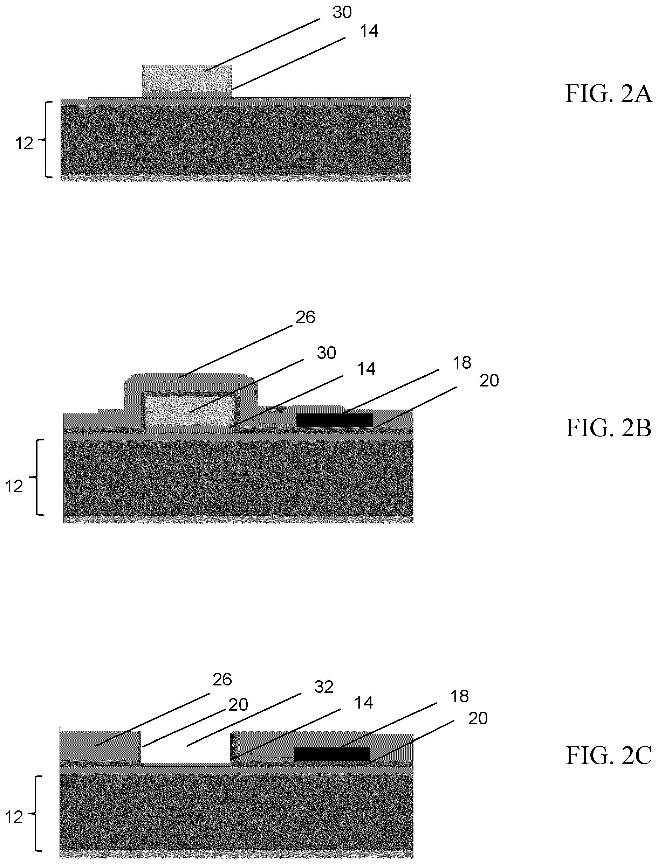

In embodiments, the inner dielectric spacers 22 will be above the gate layer 14 of the active device 10, and will surround outer edges of the gate metal 16. The inner dielectric spacers 22 and gate metal stack 16 may be self-aligned, as described with respect to FIGS. 2A-2E. The inner dielectric spacers 22 will be encapsulated between the passivation layer 20 (on an outer sidewall), the pGaN gate structure 14 (on the bottom surface of the dielectric spacers 22) and the gate metal stack 16 (on an inner side and top surface). In embodiments, the inner dielectric spacers 22 and passivation layer 20 will have a same height, below a horizontal portion 16b of the gate metal stack 16. In further embodiments, the gate metal stack 16 may be symmetrically positioned over the gate layer 14 of the active device 10 and surrounded by the inner dielectric spacers 22 that extend to an edge of the gate layer 14 of the active device 10; although other configurations are also contemplated herein.

By way of example, the gate metal stack 16 may be symmetrically offset by a distance "X" from edges of the p-GaN gate structure 14. In this way, the inner dielectric spacers 22 may be formed above p-GaN gate structure 14, laterally offsetting the gate metal stack 16 from the edges of the p-GaN gate structure 14. Moreover, the profile of the gate metal stack 16 will follow the profile of the inner dielectric spacers 22.

FIG. 1 further shows contacts (e.g., wiring layers or interconnects) 24 connecting to the metal stacks 16a, 16. In this way, the contacts 24 may be connected to the source region 17, drain region 19 and the gate layer 14 of the active device 10. The contacts (e.g., wiring layers or interconnects) 24 may be formed in interlevel dielectric material 26, e.g., oxide or nitride, other low-k dielectric materials, or combinations thereof. In embodiments, the contacts 24 may be formed by conventional lithography, etching and deposition methods as is known in the art such that no further explanation is required herein for a complete understanding of the present disclosure. The contacts 24 may be tungsten, copper, aluminum with a TaN or TiN liner, as examples; although other materials may be contemplated herein and thus these materials should not be considered a limiting feature of the present disclosure.

FIGS. 2A-2E show respective fabrication processes for manufacturing the structure of FIG. 1 in accordance with aspects of the present disclosure. As shown in FIG. 2A, for example, the p-GaN gate structure 14 can be formed on the semiconductor substrate 12, e.g., patterned, using a hardmask 30. In embodiments, the hardmask 30 can be a nitride material or other hardmask material as is known in the art.

More specifically, the p-GaN gate structure 14 will be formed by deposition of the p-GaN material, followed by the deposition of the hardmask 30 and a patterning process using conventional lithography and etching processes, e.g., reactive ion etching (RIE) as is known in the art. For example, a resist formed over the hardmask material is exposed to energy (light) and developed by utilizing a conventional resist developer to form a pattern (opening). An etching process with a selective chemistry, e.g., reactive ion etching (RIE), will be used to transfer the pattern into the hardmask material and the P-GaN material to form the gate structure 14. The resist may be removed by a conventional oxygen ashing process or other known strips.

FIG. 2B shows the formation of the field plate 18. In embodiments, a passivation layer 20 may be formed over the semiconductor substrate 12 using a conventional deposition process, e.g., CVD and ALD, or combinations of processes. The passivation layer 20 may be a nitride material, an oxide material, or may be comprised of multiple materials. A metal material can be deposited over the passivation layer 20, followed by a conventional lithography and etching process to pattern the metal material into the field plate 18. An interlevel dielectric material 26 may be blanket deposited over the field plate 18 and exposed portions of the passivation layer 20 using conventional deposition methods, e.g., CVD.

As shown in FIG. 2C, the interlevel dielectric material 26 and passivation layer 20 may be planarized using a conventional chemical mechanical planarization (CMP) process. Following the CMP process, the hardmask may be selectively removed to form a trench 32, which exposes the underlying p-GaN gate structure 14. As should be understood by those of skill in the art, the trench will have sidewalls comprising the passivation layer 20. The passivation layer 20 may also remain partly on the edges of the p-GaN gate structure 14.

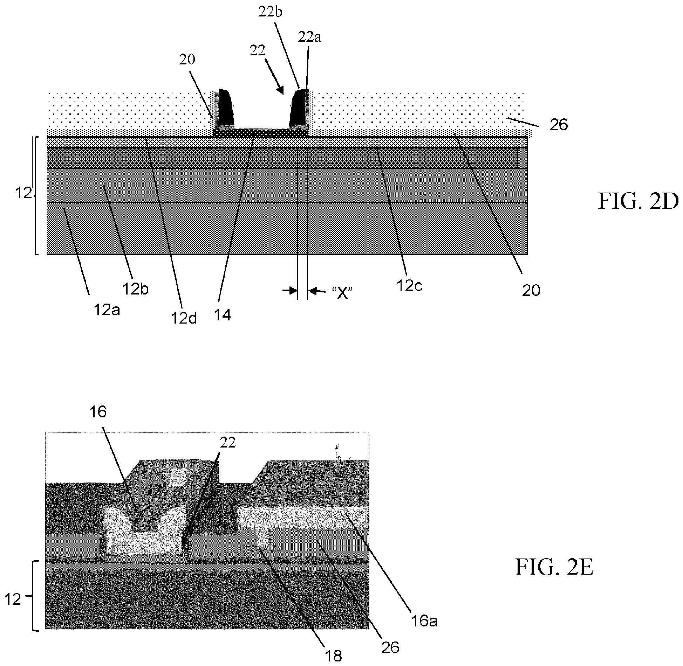

In FIG. 2D, the inner dielectric spacers 22 are formed on sidewalls of the trench 32. In embodiments, the inner dielectric spacers 22 may be formed by one or more conventional blanket deposition processes, e.g., CVD, ALD, etc., including deposition of layer 22a followed by layer 22b, followed by an etch back process, e.g., anisotropic etching process, to remove the spacer material from a top surface of the p-GaN gate structure 14. The spacer material will also be removed from the top surface of the interlevel dielectric material 26. In this way, the inner dielectric spacers 22 are self-aligned to the edges of the p-GaN gate structure 14.

FIG. 2E shows the formation of the metal stacks 16a, 16. For reference, ohmic metal 16a is not shown in the figure. By way of example, following a patterning process to expose the field plate 18, a gate metal 16 material is deposited over the inner dielectric spacers 22, in direct contact with the P-GaN Gate surface between the spacers 22, and on the exposed portion of the field plate 18. The metal material may be formed by a conventional blanket deposition process, e.g., CVD, followed by a patterning process to form the metal stacks 16a (different masking layer not shown), and gate metal 16. In this way, the gate metal stack 16 will be self-aligned to the p-GaN gate structure 14, and will also be offset from the edges of the p-GaN gate structure 14 by the inner dielectric spacers 22. The process flow continues with conventional back end of the line (BEOL) processes as described with respect to FIG. 1.

The HEMT can be utilized as a single device in discrete applications, may be combined in a single package with several other devices of the same or varying types via co-packaging or multi-chip 3D integration techniques, or may be combined with several other devices in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things. Moreover, GaN devices are increasingly being employed in SoC designs where multiple GaN HEMTs are formed on a single substrate.

The method(s) as described above is used in the fabrication of discrete devices, or integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes discrete or integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a gate structure on a semiconductor substrate;
a gate metal connecting to the gate structure and offset from edges of the gate structure; and
inner sidewall spacers on an upper surface of the gate structure and surrounding the gate metal.

2. The structure of claim 1, wherein the gate structure comprises p-GaN material and the gate metal is self-aligned to the p-GaN material.

3. The structure of claim 1 or claim 2, wherein the inner sidewall spacers comprise a dielectric material, and/or wherein the inner sidewall spacers comprise layers of dielectric material.

4. The structure of one of claims 1 to 3, wherein the gate metal is offset from edges of the gate structure by a thickness of the inner sidewall spacers.

5. The structure of one of claims 1 to 4, further comprising an outer spacer on the inner sidewall spacers.

6. The structure of claim 5, wherein the outer spacer comprises a passivation material on a sidewall of a trench in dielectric material, and the inner sidewall spacers are on an inner surface of the outer spacer in the trench, and/or wherein the outer spacer comprises a passivation material that extends onto an edge of the gate structure underneath the inner sidewall spacers, and over the semiconductor substrate.

7. The structure of claim 6, wherein the gate metal is within the trench and extends to the gate structure, and/or wherein the gate metal comprises a horizontal portion that is over the outer spacer and the inner sidewall spacers.

8. The structure of one of claims 1 to 7, wherein the gate metal is symmetrically positioned over the gate structure.

9. The structure of one of claims 1 to 8, wherein the semiconductor substrate comprises a wide-bandgap semiconductor stack of materials.

10. A structure, comprising:
wide-bandgap semiconductor layers formed on a semiconductor substrate;
a device including a gate structure over the wide-bandgap semiconductor layers;
a dielectric material over the semiconductor substrate, the dielectric material comprising a trench over the device;
inner sidewall spacers over the gate structure of the device and on sidewalls of the trench; and
a gate metal extending within the trench and connecting to the device, the gate metal being surrounded by the inner sidewall spacers.

11. The structure of claim 10, wherein the gate metal is symmetrically offset from edges of the device, and, optionally, wherein the offset is a thickness of the inner sidewall spacers.

12. The structure of claim 10 or claim 11, further comprising a passivation layer over the inner sidewall spacers.

13. The structure of claim 12, wherein the gate metal extends over the passivation layer and the inner sidewall spacers, and/or wherein the passivation layer is under the inner sidewall spacers at the offset.

14. The structure of one of claims 10 to 13, wherein the device comprises a p-GaN gate structure.

15. A method comprising:
forming a gate structure on a semiconductor substrate;
forming inner sidewall spacers on an upper surface of the gate structure; and .
forming a gate metal connecting to the gate structure surrounded by sidewall spacers and offset from edges of the gate structure.
